# EUROPEAN PATENT SPECIFICATION

(11) **EP 3 475 989 B1**
(45) Date of publication and mention of the grant of the patent: **17.03.2021**
(21) Application number: 17731770.8
(22) Date of filing: 13.06.2017
(51) Int. Cl.: H01L 35/32, H01L 35/34

(54) **FLEXIBLE THERMOELECTRIC MODULE**
FLEXIBLES THERMOELEKTRISCHES MODUL
MODULE THERMOÉLECTRIQUE FLEXIBLE

(30) Priority: 23.06.2016 US 201662353741 P
(43) Date of publication of application: 01.05.2019
(73) Proprietor: 3M Innovative Properties Company, St. Paul, MN 55133-3427 (US)
(72) Inventor: LEE, Jae Yong, Saint Paul Minnesota 55133-3427 (US); BARTON, Roger W., Saint Paul Minnesota 55133-3427 (US); BOWEN, Emily L., Saint Paul Minnesota 55133-3427 (US); CARAIG, Donato G., Singapore 768923 (SG); HUGHES, Gareth A., Saint Paul Minnesota 55133-3427 (US); PALANISWAMY, Ravi, Singapore 768923 (SG); POCH, James F., Saint Paul Minnesota 55133-3427 (US); DOLEZAL, Michael W., Saint Paul Minnesota 55133-3427 (US)
(74) Representative: Vossius & Partner Patentanwälte Rechtsanwälte mbB
(86) International application number: PCT/US2017/037117
(87) International publication number: WO 2017/222862

(56) References cited:
- EP-A1- 2 858 134
- US-A- 3 554 815
- US-A- 3 981 751
- US-A- 6 127 619
- US-A1- 2013 218 241

## Description

### Technical Field

The present disclosure relates to thermoelectric modules, devices, and tapes.

### Background

Thermoelectric power generators have been investigated to utilize temperature gradients for electrical energy generation. Traditionally, the thermoelectric generator has n-type and p-type materials, which create electric potential according to temperature gradients or heat flux through the n-type and p-type materials. There have been various efforts to harvest heat waste for renewable energy in a wide range of applications. For example, if the heat energy is dissipated from pipes, energy can be collected directly from the surface of the pipes. In addition, the harvested energy can be utilized for operating wireless sensors that are capable of detecting leaks on connections and various locations along the pipes. US 6127619 discloses a process for producing a thermoelectric module based on an additive technology using thermoelectric pastes and a patternable insulator layer. Furthermore US 3 554 815 discloses a thin flexible thermoelectric device with thermoelectric layers formed on both sides of a thin flexible substrate and connected by vias.

### Summary

At least some aspects of the present disclosure direct to a flexible thermoelectric module according to claim 1 and a process according to claim 13 comprising the steps of: providing a flexible substrate having ; a thickness between 20 and 200 micrometers with a first surface and an opposing second surface; applying a first patterned conductive layer to the first surface of the flexible substrate, wherein the pattern of first conductive layer forms a first array of connectors and each connector has two ends; generating a plurality of vias in the flexible substrate by removing materials from the flexible substrate, wherein at least some of the vias are positioned corresponding to ends of the first array of connectors; filling at least some of the vias with a thermoelectric material; applying a second patterned conductive layer to the second surface of the flexible substrate, wherein the pattern of the second conductive layer forms a second array of connectors and each connector has two ends, and wherein at least some of the ends of the second array of connectors are positioned corresponding to at least some of the vias.

At least some aspects of the present disclosure direct to a flexible thermoelectric module according to claim 6 and a process according to claim 16 comprising the steps of: providing a flexible substrate having a thickness between 20 and 200 micrometers with a first surface and an opposing second surface; applying a first patterned conductive layer to the second surface of the flexible substrate, wherein the pattern of the first conductive layer forms a first array of connectors and each connector has two ends; generating a plurality of vias in the flexible substrate by removing materials from the flexible substrate, wherein at least some of the vias are positioned corresponding to ends of the first array of connectors; filling at least some of the vias with an electrically conductive material, wherein the two ends of each connector are electrically connected to adjacent vias; placing thermoelectric elements including a plurality of p-type thermoelectric elements and a plurality of n-type thermoelectric elements on the first surface of the substrate aligning with the vias; printing a second patterned conductive layer on top of the thermoelectric elements, wherein the pattern of the second conductive layer forms a second array of connectors and each connector has two ends, and wherein at least some of the ends of the second array of connectors are positioned corresponding to at least some of the thermoelectric elements.

### Brief Description of Drawings

The accompanying drawings are incorporated in and constitute a part of this specification and, together with the description, explain the advantages and principles of the invention. In the drawings,
Figure 1A is a perspective view of one example schematic embodiment of a thermoelectric module; Figure 1B is atop view of the thermoelectric module illustrated in Figure 1A; and Figure 1C is a cross sectional view of the thermoelectric module illustrated in Figure 1A;
Figure ID is a cross-sectional view of another example embodiment of a thermoelectric module;
Figure IE is a cross-sectional view of yet another example embodiment of a thermoelectric module;
Figure 2A is a cross-sectional view of one example embodiment of thermoelectric module;
Figure 2B is a cross-sectional view of another example embodiment of thermoelectric module;
Figure 2C is a cross-sectional view of one other example embodiment of thermoelectric module;
Figures 3A-3E illustrate one embodiment of thermoelectric tape and how it can be used; and
Figures 4A-4D illustrate flow diagrams of example processes of making thermoelectric modules.

In the drawings, like reference numerals indicate like elements. While the above-identified drawings, which may not be drawn to scale, set forth various embodiments of the present disclosure, other embodiments are also contemplated, as noted in the Detailed Description. In all cases, this disclosure describes the presently disclosed disclosure by way of representation of exemplary embodiments and not by express limitations.

### Detailed Description

Unless otherwise indicated, all numbers expressing feature sizes, amounts, and physical properties used in the specification and claims are to be understood as being modified in all instances by the term "about." Accordingly, unless indicated to the contrary, the numerical parameters set forth in the foregoing specification and attached claims are approximations that can vary depending upon the desired properties sought to be obtained by those skilled in the art utilizing the teachings disclosed herein. The use of numerical ranges by endpoints includes all numbers within that range (e.g. 1 to 5 includes 1, 1.5, 2, 2.75, 3, 3.80, 4, and 5) and any range within that range.

As used in this specification and the appended claims, the singular forms "a," "an," and "the" encompass embodiments having plural referents, unless the content clearly dictates otherwise. As used in this specification and the appended claims, the term "or" is generally employed in its sense including "and/or" unless the content clearly dictates otherwise.

Spatially related terms, including but not limited to, "lower," "upper," "beneath," "below," "above," and "on top," if used herein, are utilized for ease of description to describe spatial relationships of an element(s) to another. Such spatially related terms encompass different orientations of the device in use or operation in addition to the particular orientations depicted in the figures and described herein. For example, if an object depicted in the figures is turned over or flipped over, portions previously described as below or beneath other elements would then be above those other elements.

As used herein, when an element, component or layer for example is described as being "on" "connected to," "coupled to" or "in contact with" another element, component or layer, it can be directly on, directly connected to, directly coupled with, in direct contact with, or intervening elements, components or layers may be on, connected, coupled or in contact with the particular element, component or layer, for example. When an element, component or layer for example is referred to as being "directly on," "directly connected to," "directly coupled to," or "directly in contact with" another element, there are no intervening elements, components or layers for example.

Thermoelectric devices, also referred to as thermoelectric modules, can be used as a power source for wearable devices and wireless sensors, as well as a cooling source for temperature controlling applications. A thermoelectric module converts temperature difference to electric power and typically includes a number of n-type and p-type thermoelectric elements electrically connected to generate the electrical power. For example, the thermoelectric modules can utilize body heat to generate power for wearable electronics, such as healthcare monitoring watches. In addition, the thermoelectric modules can be used as power sources to patch-type sensors, which are attached on an animal or human body to monitor health signals, for instance, electrocardiography (ECG) monitoring. The thermoelectric devices and modules can be used in either electrical power generation or cooling applications. Some aspects of the present disclosure are directed to flexible thermoelectric modules. In some embodiments, the thermoelectric module is thin, for example, with a thickness no more than 1 mm. In some cases, the thermal resistance of the thermoelectric module matches with the thermal resistance of the heat source, such that an optimum electrical power conversion is achieved. In some embodiments, the unit area thermal resistance of the flexible thermoelectric module is about 0.5 K-cm²/W, which is close to a value for the unit area thermal resistance commonly associated with liquid heat exchangers. In some embodiments, the unit area thermal resistance of the flexible thermoelectric module is less than 1.0 K-cm²/W. Since the flexible thermoelectric module can match the (relatively low) unit area thermal resistance of liquid heat exchangers, the flexible thermoelectric module can effectively generate electrical power even with these relatively high-flux sources of heat.

Some aspects of the present disclosure are directed to thermoelectric tapes, where each tape has a plurality of thermoelectric modules. In some cases, the thermoelectric tape includes a plurality of thermoelectric modules connected in parallel. In some cases, a section of the thermoelectric tape can be separated from the tape and used as a power source. In some cases, the thermoelectric tape includes two wires that can be used to output the generated power.

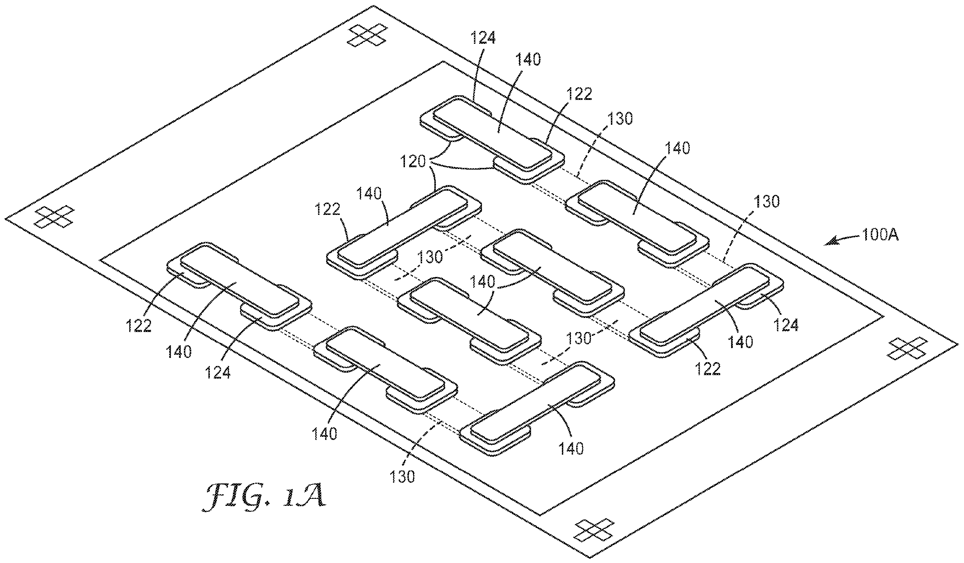

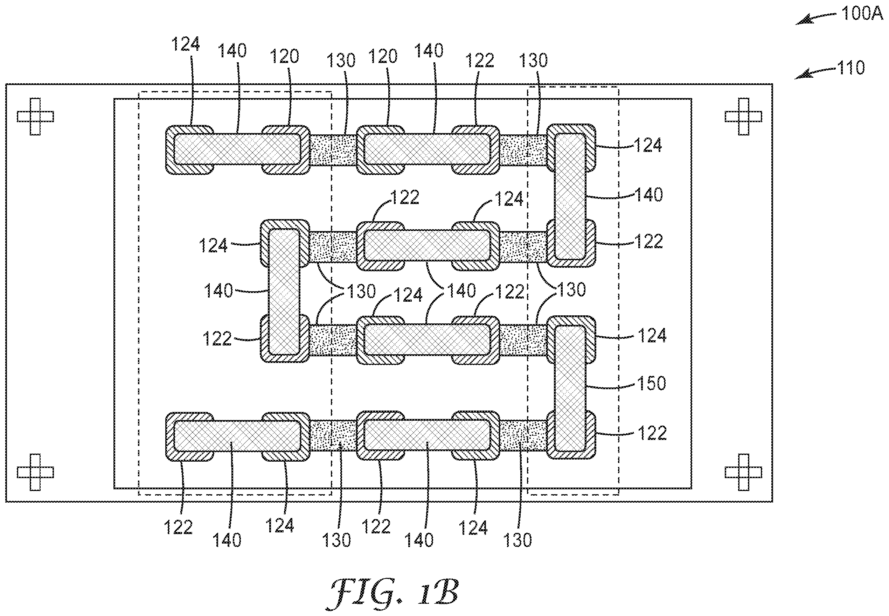

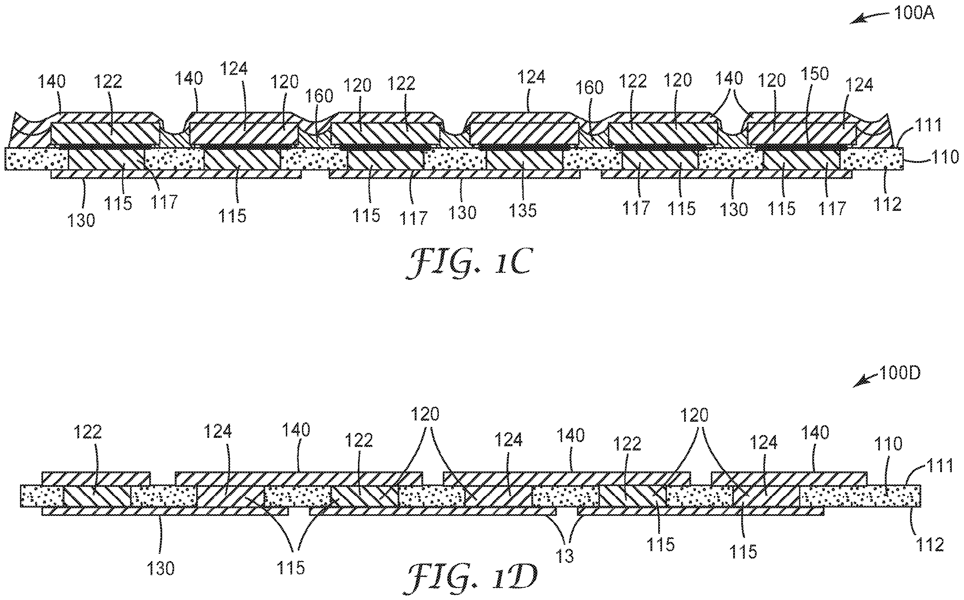

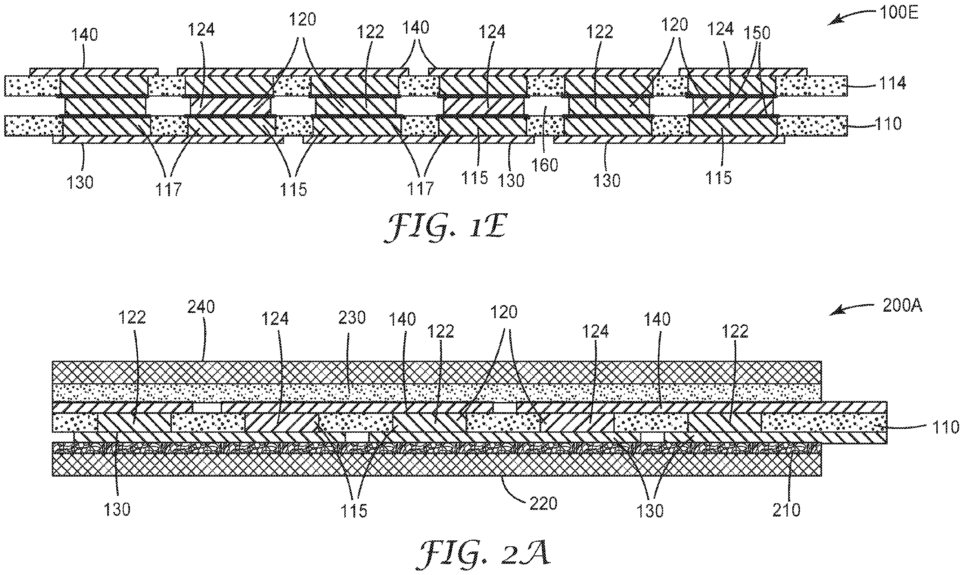

Figure 1A is a perspective view of one example schematic embodiment of a thermoelectric module 100A; Figure 1B is a top view of the thermoelectric module 100A; and Figure 1C is a cross sectional view of the thermoelectric module 100A. The thermoelectric module 100A is flexible. The thermoelectric module 100A includes a substrate 110, a plurality of thermoelectric elements 120, a first set of connectors 130, and a second set of connectors 140. In some embodiments, the substrate 110 is flexible. In the embodiment illustrated in Figure 1A, the substrate 110 includes a plurality of vias 115. In some cases, at least some of the vias are filled with an electrically conductive material 117. The flexible substrate 110 has a first substrate surface 111 and a second substrate surface 112 opposing to the first substrate surface 111. The plurality of thermoelectric elements 120 includes a plurality of p-type thermoelectric elements 122 and a plurality of n-type thermoelectric elements 124.

In some embodiments, the plurality of thermoelectric elements 120 are disposed on the first surface 111 of the flexible substrate. In some embodiments, at least part of the plurality of p-type and n-type thermoelectric elements (122, 124) are electrically connected to the plurality of vias, where a p-type thermoelectric element 122 is adjacent to an n-type thermoelectric element 124. In some cases, the first set of connectors 130, also referred to as electrodes, are disposed on the second surface 112 of the substrate 110, where each of the first set of connectors is electrically connected to a first pair of adjacent vias 115. In some cases, the second set of connectors 140 are disposed on the plurality of p-type and n-type thermoelectric elements (122, 124), where each of the second set of connectors is electrically connected to a pair of adjacent p-type and n-type thermoelectric elements. In some embodiments, the second set of connectors 140 are printed on the thermoelectric elements 120. The flow of current in the thermoelectric and the flow of heat in this example thermoelectric module is generally transverse to or perpendicular to the substrate 110 when the thermoelectric module 100 is in use. In some embodiments, a majority of heat propagates through the plurality of vias 115.

In some embodiments, the thermoelectric module 100 is used with a predefined thermal source (not illustrated), and the thermoelectric module has a thermal resistance having an absolute difference no more than 10% from a thermal resistance of the predefined thermal source. In some embodiments, the thermoelectric module has a thermal resistance having an absolute difference no more than 20% from a thermal resistance of the predefined thermal source. In some embodiments, the thermoelectric module 100 is designed to have a matching thermal resistance equal to that of the thermal resistance of the rest of the passive components transferring heat. The thermal resistance can be changed by the packing density of thermoelectric elements, dimensions of the thermoelectric elements, for example.

In some embodiments, the substrate 110 can be a flexible substrate. In some implementations, the substrate 110 can use polymer materials such as, for example, polyimide, include polyethylene, polypropylene, polymethymethacrylate, polyurethane, polyaramide, liquid crystalline polymers (LCP), polyolefins, fluoropolymer based films, silicone, cellulose, or the like. The thickness of the substrate 110 is in a range between 20 micrometers and 200 micrometers. In some cases, the thickness of the substrate 110 can be less than 100 micrometers. In some embodiments, the substrate 110 can include a plurality of vias 115. The vias 115 are usually openings through the substrate. In some cases, the plurality of vias 115 are disposed in generally equal spacing in the substrate. The width of the vias 115 can vary in the range of 0.05 mm to 5 mm, or in the range of 0.5 mm to 2 mm, or in the range of 0.1 to 0.5 mm. The spacing between adjacent vias can vary in the range of 100 µm to 10 mm, or in the range of 1 mm to 5 mm. The vias can be formed with various techniques, for example, such as laser drilling, die cutting, ion milling, or chemical etching, or the like. More techniques on forming and configurations vias or cavity in a substrate is provided in U.S. Publication No. 2013/0294471.

In some cases, the axes of the vias 115 are generally perpendicular to the major plane of the substrate 110. In some cases, the axes of the vias 115 are can be at an angle between 25° to 90° from the major plane of the substrate. In one embodiment, the axes of the vias 115 are at an angle in the range of 25° to 40° from the major plane of the substrate. In some embodiments, the vias 115 can be filled with a conductive material 117, for example, a metal, a metal composite, carbon nanotubes composite, multilayer graphene, or the like. In some embodiments, the vias 115 can be partially filled with copper or another metal and partially filled with a thermoelectric material. In some embodiments, the conductive material 117 includes no less than 50% of copper.

The thermoelectric elements 120 can include various thermoelectric materials. In one embodiment, the thermoelectric material is a chalcogenide such as Bi2Te3, Sb2Te3, or alloys thereof. In another embodiment, the thermoelectric material is an organic polymer such as PEDOT (poly(3,4-ethylenedioxythiophene)), or an organic composite such as PEDOT:PSS (poly(3,4-ethylenedioxythiophene) polystyrene sulfonate). In another embodiment, the thermoelectric material is a chalcogenide superlattice, formed on a silicon wafer, and diced into die before assembling onto the substrate 110. In another embodiment, the thermoelectric material is a doped form of porous silicon, which is diced into die before assembling onto the substrate 110.

When using organic polymers as a thermoelectric, the required processing temperatures can be decreased when compared to the chalcogenide thermoelectric material, and a wide variety of less expensive flexible substrate materials become applicable, such as polyethylene, polypropylene, and cellulose. In some cases, by processing chalcogenide materials separately, for example, in superlattice form on a silicon wafer, it is possible to improve the energy conversion efficiency (ZT value) relative to conventional thermoelectric.

In some embodiments, the thermoelectric elements 120 can be formed by thermoelectric material printed or dispensed directly on the substrate. In some cases, the thermoelectric elements 120 can be printed or dispensed directly over the vias 115 of the substrate 110. In some implementations, the thermoelectric elements are formed by printing of a thermoelectric material in paste form. After printing of the thermoelectric, the module is heat-treated so that the binder of the paste will be pyrolyzed and the thermoelectric particles sintered into a solid body. This embodiment allows for a very thin thermoelectric material in the module, with thicknesses in the range of 0.01 to 0.10 mm.

The thermoelectric elements 120 can be fabricated in a variety of ways including, for example, thin film processing, nano-material processing, micro-electro-mechanical processing, or tape casting. In one example, the starting substrate can be a silicon wafer with diameters in the range of 100 mm to 305mm (4" to 12") and with thicknesses in the range between 0.1 and 1.0 mm. In some embodiments, thermoelectric materials can be deposited onto the starting substrate by means of, for example, sputtering, chemical vapor deposition, or molecular beam epitaxy (MBE). In one embodiment, the thermoelectric elements 120 can be formed as a chalcogenide superlattice by means of MBE. Examples of these superlattice structures for thermoelectric applications include Bi₂Te₃ / Sb₂Te₃ superlattices and PbTe / PbS superlattices. By appropriate doping, both n and p-type thermoelectric superlattices can be produced. After deposition, the silicon wafer can be diced into thermoelectric elements 120 for mounting onto the substrate 110. The width of the thermoelectric elements 120 can be in the range of 0.05 to 5 mm, preferably in the range of 0.1 to 1.0 mm.

In some embodiments, the silicon wafer is used as a substrate for the formation of silicon nanofilaments, nanoholes, or other nanostructures, such as porous silicon. The silicon nanostructures can in turn be chemically modified, for instance through the formation of magnesium, lead, or bismuth silicide phases. By appropriate doping, both n and p-type thermoelectric nanostructures can be produced. After formation of nanostructures, the silicon wafer can be diced into thermoelectric elements 120 for mounting onto a polymer substrate. In some embodiments, the thermoelectric materials can be removed from the silicon substrate as a transfer layer before bonding to the substrate 110, in which case the thickness of the thermoelectric element layer to be bonded can be in the range of 0.01 to 0.2 mm.

In another embodiment, the thermoelectric elements can be formed from a tape casting process. In tape casting an inorganic precursor material, in the form of a paste, is cast or silk-screened onto a smooth refractory setter, such as alumina, aluminum nitride, zirconia, silicon carbide, molybdenum. The tape is then sintered at high temperature to form the desired thermoelectric compound, in thicknesses that range from 0.1 to 5.0 mm. After sintering, the tape can be diced thermoelectric elements 120 for mounting onto the substrate 110 in die form.

In some embodiments, the first set of connectors can be formed from a metal, for example, copper, silver, silver, gold, aluminum, nickel, titanium, molybdenum, or the like, or a combination thereof. In one embodiment, the first set of connectors are formed from copper. For example, the connectors can be formed by sputtering, by electrodeposition, or by lamination of copper sheets. In some implementations, the copper pattern can be defined photolithographically using a dry film resist, followed by etching. The thickness of the first set of connectors 130 can range from 1 micrometer to 100 micrometers. In one embodiment, a polyimide substrate 110 with copper connectors 130 can use flexible printed circuit technology. Details on flexible circuit technology are provided in U.S. Patents Nos. 6,611,046 and 7,012,017.

Disposed over the top of the thermoelectric elements 120 are a set of second connectors 140. The connectors 140 can be formed, for example, from a deposited or printed metal pattern. The metal can be, for example, copper, silver, gold, aluminum, nickel, titanium, molybdenum, or combinations thereof. In some embodiments, the metal pattern is formed by silk screen printing using a metal-composite ink or paste. In other embodiments, the metal pattern can be formed by flexographic printing or gravure printing. In some embodiments, the metal pattern can be formed by ink printing. In yet some other embodiments, the metal pattern can be deposited by means of sputtering or chemical vapor deposition (CVD) followed by photolithographic patterning and etching. In some embodiments, the connectors 140 may have thicknesses in the range of 1 micrometer to 100 micrometers. In some implementations, the thickness of the thermoelectric module 100A is no greater than 1 mm. In some implementations, the thickness of the thermoelectric module 100A is no greater than 0.3 mm. In some cases, the thickness of the thermoelectric module 100A in a range between 50 micrometers and 500 micrometers.

In some embodiments, at least each of a part of the two sets of connectors (130, 140) makes an electrical connection between two adjacent thermoelectric elements - one p-type thermoelectric element and one n-type thermoelectric element. In one embodiment, a connector 130 electronically connects a first pair of thermoelectric elements and a connector 140 electronically connects a second pair of thermoelectric elements, where the first pair of thermoelectric elements and the second pair of thermoelectric elements have one thermoelectric in common. In some cases, the spacing between two adjacent thermoelectric elements 120 can partially depend on the connectors (130, 140) placement accuracy. In one example embodiment, the connector placement accuracy is 10 micrometers and the spacing between two adjacent thermoelectric elements 120 is 10 micrometer.

In some embodiments, the thermoelectric module 110A includes bonding components 150. In the embodiment illustrated in Figure 1C, the bonding components are disposed between the thermoelectric elements 120 and the vias 115 filled with conductive material. In some embodiments, the bonding components 150 can include a bonding material including, for example, a solder material, a conductive adhesive, or the like. In one embodiment, the bonding material can be a solder material containing various mixtures of lead, tin, bismuth, silver, indium, or antimony. In another embodiment, the bonding material can be an anisotropic conductive adhesive, for example, the 3M adhesive 7379.

In some embodiments, the width of the bonding components 150 is greater than the width of the vias 115. In some embodiments, the width of the thermoelectric elements 120 is greater than the width of the vias 115. In one embodiment, the difference in width between the thermoelectric elements and the vias is no less than the thickness of the thermoelectric elements. As an example, if the thickness of the thermoelectric elements is 80 micrometers, the difference in width between the thermoelectric elements and the vias is at least 80 micrometers. In one embodiment, the width of the thermoelectric elements is substantially equal to the width of the vias.

In some embodiments, disposed in the spaces between the thermoelectric elements 120 is an insulator 160. In some cases, the insulator 160 can protects the sides of the thermoelectric elements 120 during a final metallization step. In some cases, the insulator 160 fills spaces between the thermoelectric elements and does not make contact with the top of the thermoelectric elements 120. In some other cases, the insulator 160 covers a portion of the top of the thermoelectric elements 120. In one embodiment, the insulator 160 is a low temperature fusible inorganic material which can be applied as a paste or ink by means of silk screening or drop-on-demand (ink-jet) printing. An example would be a paste made from a boron or sodium doped silicate or glass frit material. After printing, the glass frit can be melted in place to form a seal around the thermoelectric elements. In some embodiments, the insulator 160 is an organic material that can be applied by a silk screen printing process, a drop-on-demand printing process, or by flexographic or gravure printing. Examples of printable organic insulator materials include acrylics, polymethylmethacrylate, polyethylene, polypropylene, polyurethane, polyaramide, polyimide, silicone, and cellulose materials. In another embodiment, the insulator is a photo-imageable organic dielectric material, such as a silsesquioxane, benzocyclobutane, polyimide, polymethylmethacrylate, or polybenzoazole. In another embodiment, the insulator 160 is formed as a spin-on glass using precursors such as, for example, a meth-alkyl or meth-alkoxy siloxane compound. After deposition, the spin-on glass can be patterned using a photoresist and etching technique.

In some implementations, an array of "drop-on-demand" nozzles can be used to apply the insulator 160 of a low-viscosity dielectric liquid solution directly to the substrate at several sites across the thermoelectric module 110A. The liquid will flow and be distributed within spaces between adjacent thermoelectric elements by means of capillary pressure. While the liquid insulator 160 flows in microchannels between thermoelectric elements, the liquid insulator 160 is confined to below a level defined by the upper edges of the thermoelectric elements, such that the liquid insulator 160 does not flow onto or cover the top face of the thermoelectric elements 120. In some cases, the liquid insulator 160 can be a polymeric material dissolved in a carrier solvent or a curable monomer. In some cases, the liquid insulator 160 travels a certain distance from each dispensing site, dictated by rheology, surface energetics and channel geometry. In some cases, the liquid insulator 160 is dispensed at periodic sites in the substrate 110 to ensure a continuous coverage of the spacing among the thermoelectric elements 120.

Figure ID is a cross-sectional view of another example embodiment of a thermoelectric module 100D. The thermoelectric module 100D includes a substrate 110, a plurality of thermoelectric elements 120, a first set of connectors 130, and a second set of connectors 140. Components with same labels can have same or similar configurations, production processes, materials, compositions, functionality and/or relationships as the corresponding components in Figure 1A. In some embodiments, the substrate 110 is flexible. In some embodiments, the substrate 110 includes a plurality of vias 115. The flexible substrate 110 has a first substrate surface 111 and a second substrate surface 112 opposing to the first substrate surface 111. The plurality of thermoelectric elements 120 includes a plurality of p-type thermoelectric elements 122 and a plurality of n-type thermoelectric elements 124.

In the embodiment illustrated in Figure ID, the thermoelectric elements 120 are disposed within the vias 115. In some cases, the thermoelectric elements include a thermoelectric material. In one embodiment, the thermoelectric material is a V-VI chalcogenide compound such as Bi₂Te₃ (n-type) or Sb₂Te₃ (p-type). The V-VI chalcogenides are sometimes improved through alloyed mixtures such as Bi₂Te₃-_{X}Se_{X} (n-type) or Bi_{0.5}Sb_{1.5}Te₃ (p-type). In another embodiment, the thermoelectric material is formed from an IV-VI chalcogenide material such as PbTe or SnTe or SnSe. The IV-VI chalcogenides can sometimes be improved through doping, such as Pb_{X}Sb1-_{X}Te or NaPb₂₀SbTe₂₂. In yet another embodiment, the thermoelectric material is formed from a silicide, such as Mg₂Si, including doped versions such as Mg₂Si_{X}Bi10_{X} and Mg₂Si0.6Sn_{0.4}. In an alternate embodiment, the thermoelectric material is formed from a clathrate compound, such as Ba₂Ga₁₆Ge₃₀. In yet another embodiment, the thermoelectric material is formed from a skutterudite compound, such as BaxLayCo₄Sb₁₂ or BaxInyCo₄Sb₁₂. In an alternate embodiment, the thermoelectric material can be formed from transition metal oxide compounds, such as CaMnO₃, NaxCoO₂ or Ca₃Co₄O₉.

In some implementations, the inorganic materials listed above are generally synthesized by means of a powder process. In the powder process, constituent materials are mixed together in powder form according to specified ratios, the powders are then pressed together and sintered at high temperature until the powders react to form a desired compound. After sintering, the powders can be ground and mixed with a binder or solvent to form a slurry, ink, or paste. In some implementations, thermoelectric elements 120 in the form of a paste can be added to the vias 115 in the substrate 110 by means of a silk screen deposition process or by a doctor-blade process. In some implementations, thermoelectric elements 120 can also be placed in the vias 115 by means of a "drop-on-demand" ink jet process. In some implementations, thermoelectric elements 120 can also be added to the vias 115 by means of a dry-powder jet or aerosol process. In some implementations, thermoelectric elements 120 can also be added to the vias 115 by means of flexographic or gravure printing.

In an alternative embodiment to the powder synthesis process, thermoelectric particles of the correct stoichiometery can be formed and recovered directly from a solvent mixture by means of reactive precipitation. In another alternative embodiment, the thermoelectric material can react within a solvent and then be held in the solvent as a colloidal suspension for use directly as nano-particle ink.

In some cases, after printing of the thermoelectric material into the vias 115, the substrate 110 is heat-treated so that the binder is pyrolyzed, and the thermoelectric material is sintered into a solid body with bulk-like thermal and electrical conductivity.

In one embodiment, the vias 115 in the substrate 110 can be filled with a carbon-based organic material, such as the thiophene PEDOT. In an alternative embodiment, the thermoelectric elements 120 can be formed from a composite such as PEDOT:PSS or PEDOT:ToS. In an alternative embodiment, the thermoelectric elements 120 can be formed from a polyaniline (PANi). In an alternative embodiment, the thermoelectric elements 120 can be formed from a polyphenylene vinylene (PPV). In an alternative embodiment, the thermoelectric elements 120 can be formed by composites between inorganics and organics. In an alternative embodiment, thermoelectric elements 120 can be formed between a conductive organic binder and nano-filaments such as, for example, carbon nanowires, tellurium nanowires, or silver nanowires. In some implementations, thermoelectric elements formed with organic thermoelectric materials can be deposited within the vias 115 by means of either a silk screen process, or by an ink-jet process, or by flexographic or gravure printing.

Figure IE is a cross-sectional view of yet another example embodiment of a thermoelectric module 100E. The thermoelectric module 100E includes a first substrate 110, a second substrate 114, a plurality of thermoelectric elements 120, a first set of connectors 130, and a second set of connectors 140. Components with same labels can have same or similar configurations, production processes, materials, compositions, functionality and/or relationships as the corresponding components in Figures 1A-1C. In some embodiments, one of or both of the substrates (110, 114) are flexible. In some embodiments, both of the substrate (110, 114) includes a plurality of vias 115. In some cases, a conductive material 117 is disposed in the vias 115. The plurality of thermoelectric elements 120 includes a plurality of p-type thermoelectric elements 122 and a plurality of n-type thermoelectric elements 124.

In some cases, the thermoelectric elements 120 are bonded over the top of each of the vias 115 filled with the conductive material 117 in the first or bottom substrate 110 via the bonding components 150. The second substrate 114 is then positioned over the top of the first substrate 110 and bonded via bonding components 150, such that each one of the vias 115 filled with the conductive material 117 in the second substrate 114 makes electrical contact with one of the thermoelectric elements 120.

In the embodiment illustrated, the connectors (130, 140) are arranged on both the first and second substrates (110, 114) such that a continuous electrical current can flow from one thermoelectric element to another thermoelectric element. In some embodiments, when flowing through the thermoelectric elements, the flow of current within the n-type and p-type die are in opposite directions, for example, the current flows from bottom to the top in the n-type thermoelectric element and from top to bottom in the p-type thermoelectric element. The flow of currents in the thermoelectric and the flow of heat in this example thermoelectric module is generally transverse to or perpendicular to the plane of the two substrates (110, 114). In some embodiments, the insulator 160 is a low temperature fusible inorganic material which can applied as a paste or ink by means of silk screening or drop-on-demand (ink-jet) printing. In some embodiments, the insulator 160 is an insulating material in gas form, for example, air.

Figure 2A is a cross-sectional view of one example embodiment of thermoelectric module 200A. The thermoelectric module 200 includes a first substrate 110 having a plurality of vias 115, a plurality of thermoelectric elements 120 disposed in the vias 115, a first set of connectors 130, a second set of connectors 140, an optional abrasive protection layer 210, an optional release liner 220 for the abrasive protection layer 210, an optional adhesive layer 230, and an optional release liner 240 for the adhesive layer 230. Components with same labels can have same or similar configurations, production processes, materials, compositions, functionality and/or relationships as the corresponding components in Figures 1A-1E. In the embodiment illustrated, the abrasion protective layer 210 is disposed adjacent to the first sets of connectors 130 and the release liner disposed adjacent to the abrasive protection layer. In some cases, the adhesive layer 230 is disposed adjacent to one of the first and second sets of connectors 140 and the release liner 240 is disposed adjacent to the adhesive layer 230. In some embodiments, the abrasion protection layer and/or the adhesive layer is selected with a thermally conductive property providing mechanical robustness, for example, carbon nanotube composites or graphene thin films mixed with adhesive materials.

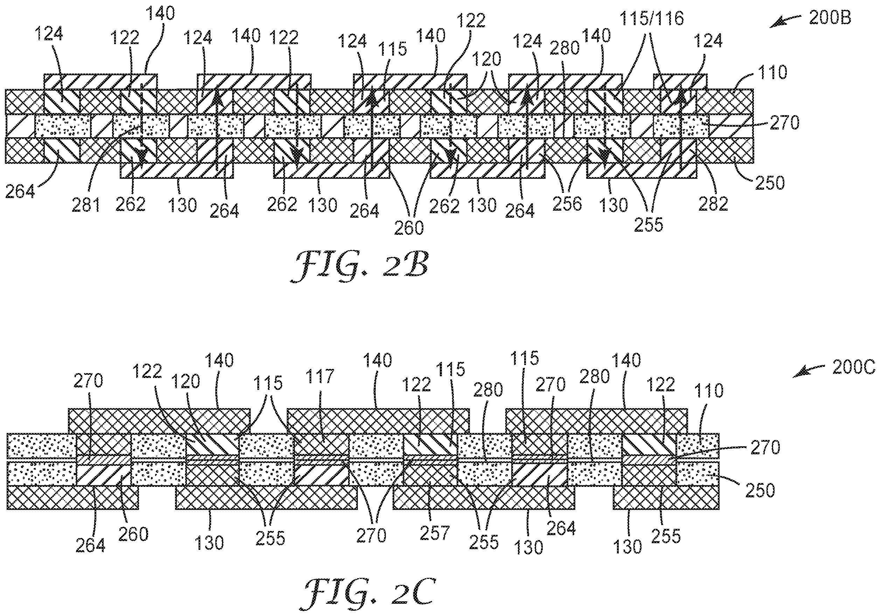

Figure 2B is a cross-sectional view of one example embodiment of thermoelectric module 200B. The thermoelectric module 200B includes a first substrate 110 having a first set of vias 115, a first set of thermoelectric elements 120 disposed in the first set of vias 115, a second substrate 250 having a second set of vias 255, a second set of thermoelectric elements 260 disposed in the second set of vias 255, a plurality of conductive bonding components 270 sandwiched between the first substrate and the second substrate, a first set of connectors 130, and a second set of connectors 140. Components with same labels can have same or similar configurations, production processes, materials, compositions, functionality and/or relationships as the corresponding components in Figures 1A-1E. In some implementations, at least one of the first substrate 110 and the second substrate 250 is flexible. In some cases, each conductive bonding component 270 is aligned to a first via in the first set of vias 115 and a second via in the second set of vias 255.

In some embodiments, the first set of connectors 130 are disposed on a surface of the first substrate 110 away from the bonding components 270 and each of the first set of connectors 130 is electrically connecting to a first pair of adjacent vias 116 of the first set of vias 115. In some cases, the second set of connectors 140 are disposed on a surface of the second flexible substrate away from the bonding component 270 and each of the second set of connectors is electrically connecting to a second pair of adjacent vias 256 of the second set of vias 255. In the embodiment illustrated, the first pair of adjacent vias 116 and the second pair of adjacent vias 256 have one via aligned and one via not aligned. As illustrated, current can flow in the directions 281, 282 generally perpendicular to the substrates (110, 250).

In some embodiments, a different one of p-type thermoelectric element 122 and n-type thermoelectric elements 124 are disposed in two adjacent vias of the first set of vias 115. In such embodiments, a different one of p-type thermoelectric element 262 and n-type thermoelectric elements 264 are disposed in two adjacent vias of the second set of vias 255. Further, a via 115 in the first flexible substrate 110 is generally aligned with a via 255 in the second flexible substrate 250 have a same type of thermoelectric element.

In some embodiments, an insulating material 280 is disposed between adjacent bonding components 270. In some embodiments, the bonding components 270 can use a conductive adhesive material, for example, anisotropic conductive film, electrically conductive adhesive transfer tape, or the like. The insulating material 280 can be, for example, polyimide, polyethylene, polypropylene, polyurethane, silicone, or the like.

Figure 2C is a cross-sectional view of one example embodiment of thermoelectric module 200C. The thermoelectric module 200C includes a first substrate 110 having a first set of vias 115, a first set of thermoelectric elements 120 disposed in the first set of vias 115, a second substrate 250 having a second set of vias 255, a second set of thermoelectric elements 260 disposed in the second set of vias 255, a plurality of conductive bonding components 270 sandwiched between the first substrate and the second substrate, a first set of connectors 130, and a second set of connectors 140. Components with same labels can have same or similar configurations, production processes, materials, compositions, functionality and/or relationships as the corresponding components in Figures 1A-1E. In some implementations, at least one of the first substrate 110 and the second substrate 250 is flexible. In some cases, each conductive bonding component 270 is aligned to a first via in the first set of vias 115 and a second via in the second set of vias 255.

In some embodiments, the first set of thermoelectric elements 120 are of a first type of thermoelectric elements, for example, p-type or n-type thermoelectric elements. In such embodiments, the second set of thermoelectric elements 260 are of a second type of thermoelectric elements that is different from the first type of thermoelectric elements. For example, the first type of thermoelectric elements is p-type and the second type of thermoelectric elements is n-type, or vice versa. In the embodiment illustrated, a thermoelectric element of the first type and a first conductive material 117 are disposed in two adjacent vias of the first set of vias 115. A thermoelectric element of the second type and a second conductive material 257 are disposed in two adjacent vias of the second set of vias 255. In such embodiment, a via having the thermoelectric element of the first type in the first substrate 110 is generally aligned with a via having the second conductive material 257 in the second substrate 250. A via having the first conductive material 117 is generally aligned with a via having the thermoelectric element of the second type in the second substrate 250. In some cases, the first conductive material 117 is the same as the second conductive material 257. In some cases, the first conductive material 117 is different from the second conductive material 257.

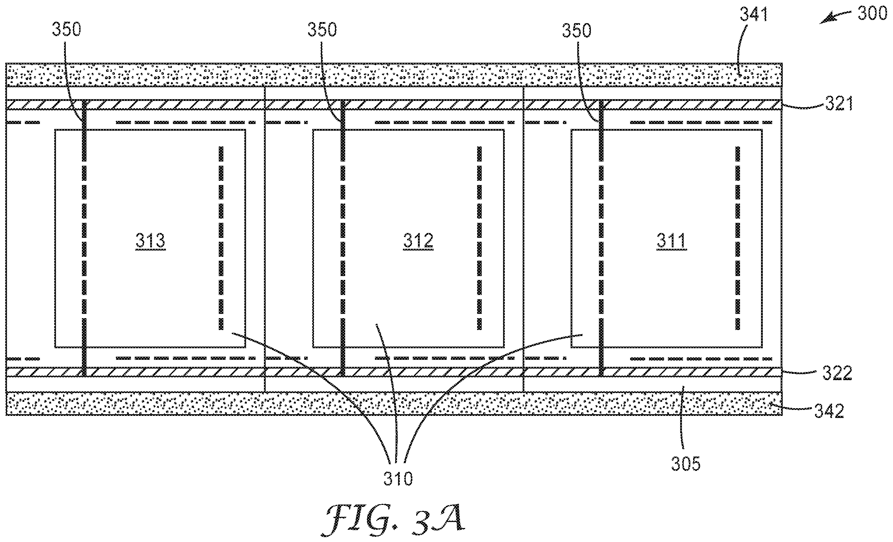

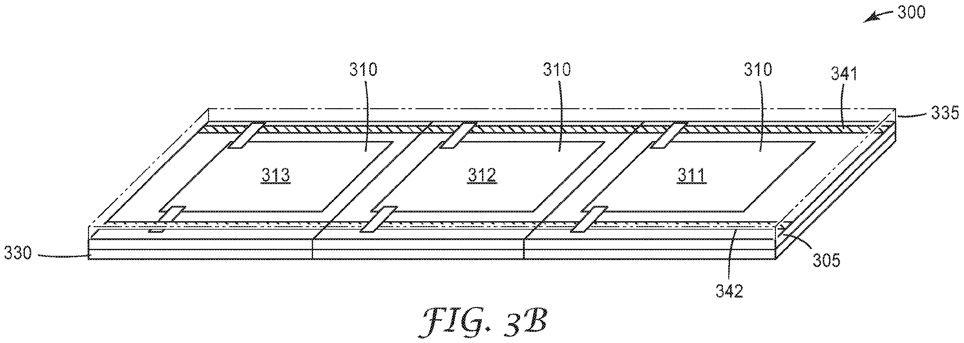

In some embodiments, thermoelectric modules can be provided in a tape form. In some cases, the tape is in a roll form. Figures 3A-3E illustrate one embodiment of thermoelectric tape 300 and how it can be used. Figure 3B is an exploded view of the thermoelectric tape 300. In some embodiments, the thermoelectric tape 300 includes a flexible substrate 305, a plurality of thermoelectric modules 310, and two conductive buses (321, 322) running parallel longitudinally along the thermoelectric tape. The thermoelectric module 310 can use any configuration of thermoelectric modules described herein. In some cases, the flexible substrate 305 includes a plurality of vias. In some embodiments, the plurality of thermoelectric modules 310 are connected in parallel. The thermoelectric modules 310 generates a certain amount of electric current and voltage for a given temperature gradient. Given the same density of n-type and p-type thermoelectric elements included, the larger sized module provides higher output current and voltage. In addition, a higher density of thermoelectric elements creates higher output voltage.

In some cases, the thermoelectric tape 300 includes a thermally conductive adhesive layer 330 disposed on a first surface of the flexible substrate 305, as illustrated in Figure 3B. In some cases, the thermoelectric tape 300 includes an optional protective film 335. In some embodiments, a stripe of thermal insulating material 341 is disposed longitudinally along the thermoelectric tape 300. In some cases, two stripes of thermal insulating material 341, 342 are disposed longitudinally along the thermoelectric tape 300, each of the two stripes of thermal insulating material disposed at an edge of the thermoelectric tape 300. In some embodiments, the thermal insulating materials will overlap one another, thereby preventing thermal loss leaking through the spacing between the tapes, for example, when wrapped around a heat pipe.

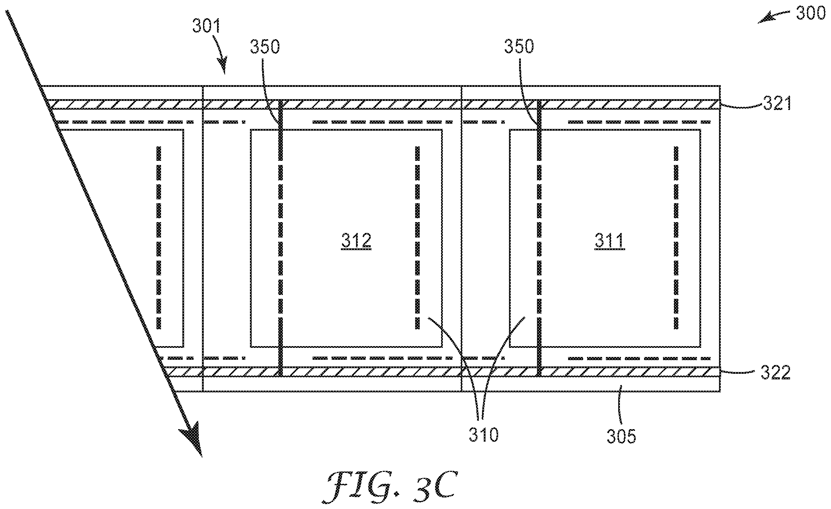

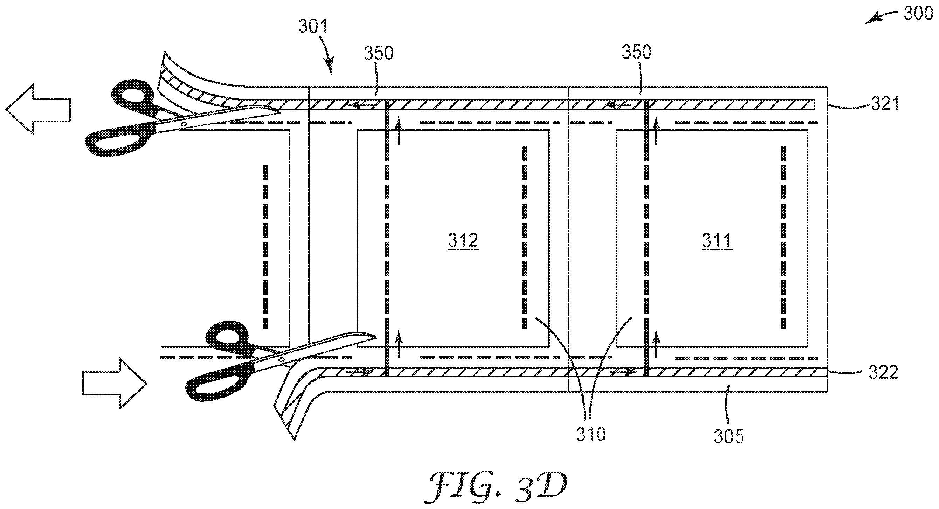

As illustrated in Figure 3C, in some cases, a section of the thermoelectric tape 301 can be separated, for example, within the thermoelectric module 313, such that the section of thermoelectric tape includes thermoelectric modules 311 and 312. The section of the thermoelectric tape 301 can be used as a power source by outputting power at the buses (321, 322), as illustrated in Figure 3D. In some embodiments, the thermoelectric tape 300 includes a plurality of lines of weakness 350, where each line of weakness is disposed between adjacent two flexible thermoelectric modules of the series of flexible thermoelectric modules 310. In such embodiments, the line of weakness 350 allows separation of a section of the thermoelectric tape. In some cases, a section of the thermoelectric tape 301 can be designed based on the power requirement.

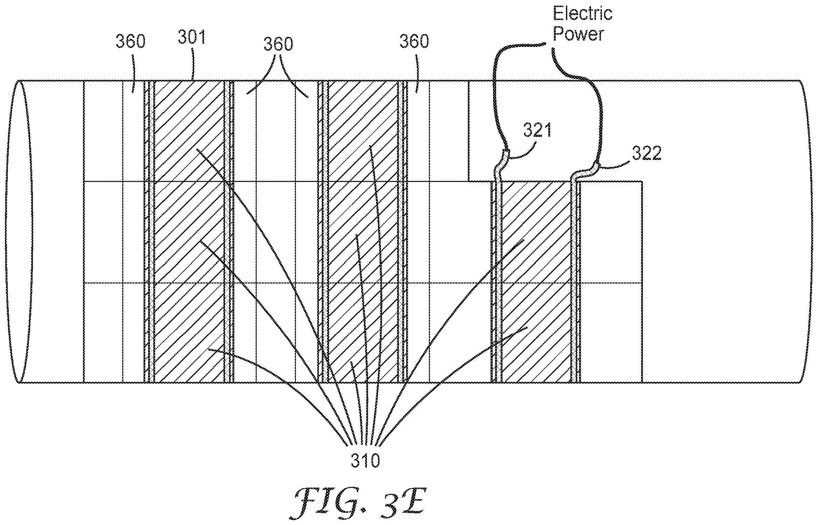

Figure 3E shows an example use of the section of thermoelectric tape 301 to wrap around a heat source such as, for example, a steam pipe. In some cases, a thermal insulation stripes 360 is disposed between the thermoelectric modules 310. In some cases, the thermal insulating stripes 360 are formed from the thermal insulating stripes 341, 342 of the thermoelectric tape 300 illustrated in Figure 3A.

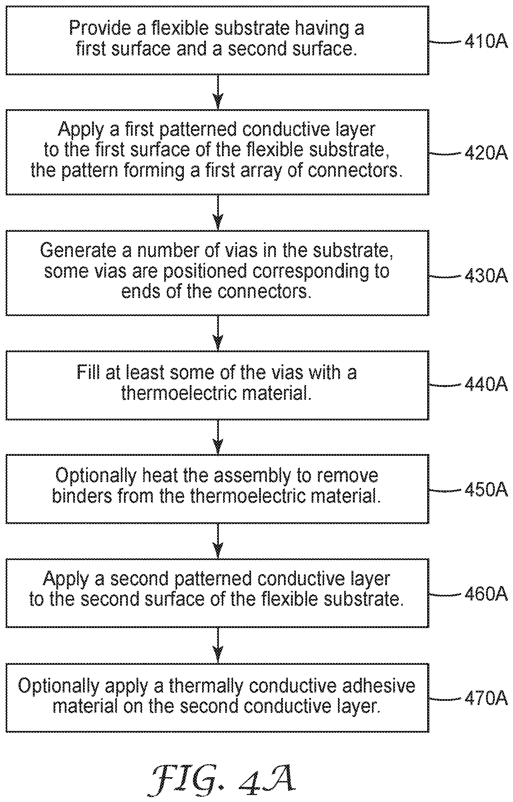

Figures 4A-4D illustrate flow diagrams of example processes of making thermoelectric modules. Some of the steps are optional. Some of the steps may be changed in order. Figure 4A illustrates a flow diagram of one example process of an assembly line making a thermoelectric module. The process can generate a thermoelectric module as illustrated in Figure ID. In such implementations, the thermoelectric module can be thin because of having less layers, such that the module can have higher flexibility and be effective in converting thermal power into electrical power. Each component of the thermoelectric module can use any configurations and embodiments of the corresponding component described herein. First, provide a flexible substrate having a first surface and an opposing second surface (step 410A). Next, apply a first patterned conductive layer to the first surface of the flexible substrate (step 420A), where the pattern of first conductive layer forms a first array of connectors and each connector has two ends. In some cases, the first conductive layer can be formed using flexible printed circuit technology. In some cases, the first conductive layer can be formed by sputtering, electrodeposition, or by lamination of a conductive sheet. In some implementations, the pattern of the first conductive layer can be defined photolithographically using a dry film resist, followed by etching. In some other implementatons, the pattern of the first conductive layer can be formed by silk screen printing using a metal-composite ink or paste. In some cases, the pattern of the first conductive layer can be formed by flexographic printing or gravure printing. In some cases, the pattern of the first conductive layer can be formed by ink printing.

In some cases, the assembly line generates a number of vias in the flexible substrate (step 430A), for example, by removing materials from the flexible substrate. In some embodiments, at least some of the vias are positioned corresponding to ends of first array of connectors. Methods for forming vias include laser drilling, die cutting, ion milling, chemical etching, or the like. If the first conductive layer was formed by the lamination of copper sheets, then the lamination adhesive is also removed from the bottom of the vias during the etching step. Further, fill at least some of the vias with a thermoelectric material (step 440A). In some implementations, the thermoelectric material in the form of a paste can be added to the vias by means of a silk screen deposition process or by a doctor-blade process. In some implementations, the thermoelectric material are synthesized by means of a powder process. In the powder process, constituent materials are mixed together in powder form according to specified ratios, the powders are then pressed together and sintered at high temperature until the powders react to form a desired compound. After sintering, the powders can be ground and mixed with a binder or solvent to form a slurry, ink, or paste. In some implementations, the thermoelectric material can also be placed in the vias by means of a "drop-on-demand" ink jet process. In some implementations, the thermoelectric material can also be added to the vias by means of a dry-powder jet or aerosol process. In some implementations, the thermoelectric material can also be added to the vias by means of flexographic or gravure printing.

In some implementations, the thermoelectric material comprises a binder material. Optionally, heat the thermoelectric module to remove the binder material (step 450A). In some embodiments, the binder material can be, for example, carboxymethyl cellulose, polyvinyl alcohol (PVA), polyvinylpyrrolidone (PVP), or the like. In some cases, if the thermoelectric material added to the vias is in the form ink or paste, the substrate filled with thermoelectric material may be heat-treated so that binders and solvents in the paste are evaporated or pyrolyzed, so that the thermoelectric material is sintered into a solid body with bulk-like thermal and electrical conductivity. Pyrolization of organic binders can occur over temperature ranges between 120°C and 300°C. Sintering of the thermoelectric materials can occur over temperature ranges between 200°C and 500°C. For some implementations, it is preferable to heat treat the thermoelectric material in atmospheres of nitrogen or forming gas, to avoid oxidation of the thermoelectric material.

Next, apply a second patterned conductive layer to the second surface of the flexible substrate (step 460A), where the pattern of the second conductive layer forms a second array of connectors and each connector has two ends. In some embodiments, at least some of the ends of the second array of connectors are positioned corresponding to at least some of the vias. The second conductive layer and its pattern can be formed using a process forming the first conductive layer and its pattern.

In some implementations, the assembly line applies a thermally conductive adhesive material on the second patterned conductive layer (step 470A). In some cases, an adhesive layer, optionally with a release liner, can be coated or laminated over a surface of the thermoelectric module. In some embodiments, it is preferable to provide an adhesive layer with a thermally conductive property. This can be accomplished with techniques known in the art such as dispersing gold, silver, or carbon particles, filaments, or flakes within the matrix of the adhesive. The thickness of the thermally conductive adhesive layer is preferably in a range between 10 micrometers and 100 micrometers. The adhesive layer can be coated directly onto the thermoelectric module by means of either an aqueous or solvent-based coating process or by means of a hot-melt extrusion process. In another embodiment, the thermally conductive adhesive layer is prepared as a separate tape article that can be laminated over the top of the thermoelectric module along with a release liner.

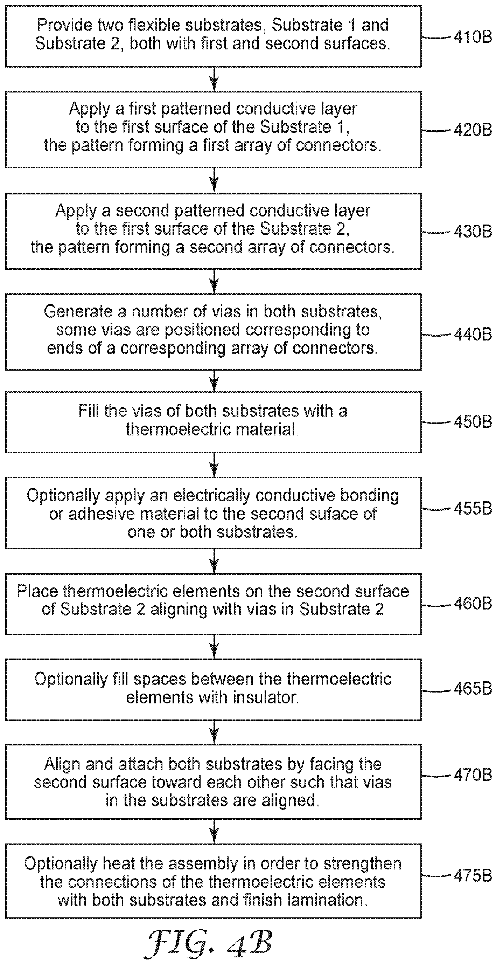

Figure 4B illustrates a flow diagram of another example process of an assembly line making a thermoelectric module. The process can generate a thermoelectric module as illustrated in Figure IE. Each component of the thermoelectric module can use any configurations and embodiments of the corresponding component described herein. Each step can use any embodiments of the corresponding step described in Figure 4A. First, provide two flexible substrates, Substrate 1 and Substrate 2, both with a first and second surfaces (step 410B). Apply a first patterned conductive layer to the first surface of Substrate 1, the pattern forming a first array of connectors (step 420B). Apply a second patterned conductive layer to the first surface of Substrate 2, the pattern forming a second array of connectors (step 430B). Generate a number of vias in both substrates, some of the vias are positioned corresponding to ends of a corresponding array of connectors (step 440B). Fill the vias of both substrates with an electrically conductive material (step 450B). In some cases, the electrically conductive material can be in the form of solution, ink, paste, or solid. In some cases, the electrically conductive material is filled in the vias by any feasible process, for example, by printing, by vacuum deposition, by silk screen printing, or the like.

Optionally, apply an electrically conductive bonding or adhesive material to the second surface of one or both substrates (step 455B). Place thermoelectric elements on the second surface of Substrate 2 aligning with vias in Substrate 2 (step 460B). Optionally, fill spaces between the thermoelectric elements with insulator (step 465B). Align and attach both substrates by facing the second surface toward each other such that vias in the substrates are aligned (step 470B). In such implementations, the conductive layers are on the outer surfaces of the assembly, and the thermoelectric elements are between the two substrates. Optionally, heat the assembly in order to strengthen the connections of the thermoelectric elements with both substrates and finish lamination (step 475B).

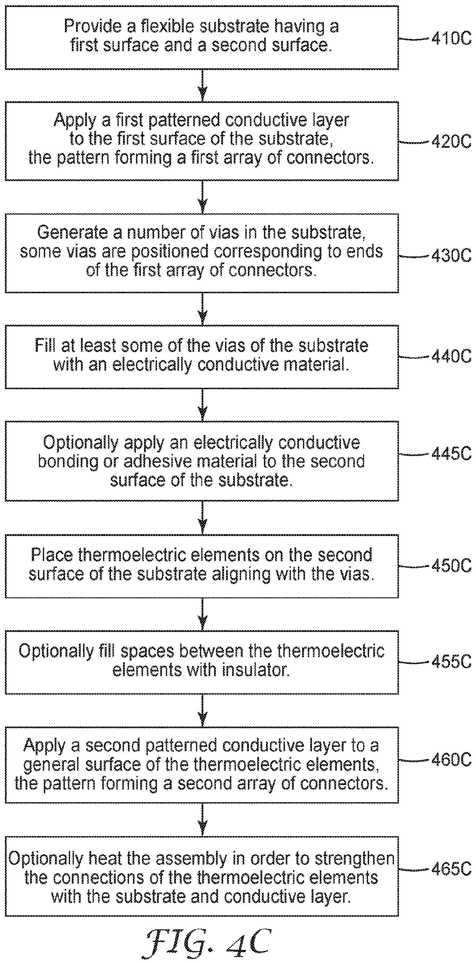

Figure 4C illustrates a flow diagram of another example process of an assembly line making a thermoelectric module. The process can generate a thermoelectric module as illustrated in Figures 1A-1C. Each component of the thermoelectric module can use any configurations and embodiments of the corresponding component described herein. Each step can use any embodiments of the corresponding step described in Figure 4A. First, provide a flexible substrate having a first and second surfaces (step 410C). Apply a first patterned conductive layer to the first surface of Substrate 1, the pattern forming a first array of connectors (step 420C). Generate a number of vias in both substrates, some of the vias are positioned corresponding to ends of a corresponding array of connectors (step 430C). Fill the vias of both substrates with an electrically conductive material (step 440C). In some cases, the electrically conductive material can be in the form of solution, ink, paste, or solid. In some cases, the electrically conductive material is filled in the vias by any feasible process, for example, by printing, by vacuum deposition, by silk screen printing, or the like.

Optionally, apply an electrically conductive bonding or adhesive material to the second surface of the substrate (step 445C). Place thermoelectric elements on the second surface of the substrate aligning with the vias in the substrate (step 450C). Optionally, fill spaces between the thermoelectric elements with insulator (step 455C). Apply a second patterned conductive layer to a general surface of the thermoelectric elements, the pattern forming a second array of connectors (step 460C). Optionally, heat the assembly in order to strengthen the connections of the thermoelectric elements with both substrates and finish lamination (step 465C).

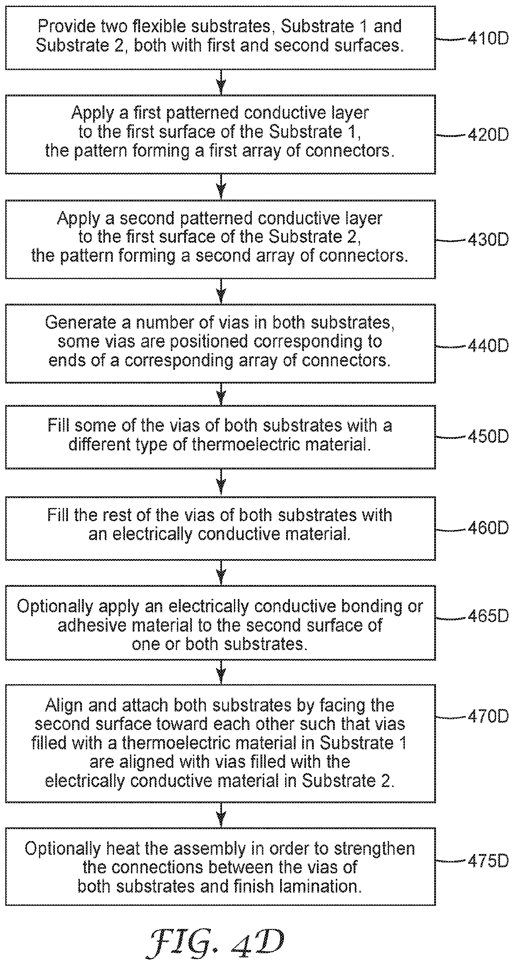

Figure 4D illustrates a flow diagram of another example process of an assembly line making a thermoelectric module. The process can generate a thermoelectric module as illustrated in Figure 2C. Each component of the thermoelectric module can use any configurations and embodiments of the corresponding component described herein. Each step can use any embodiments of the corresponding step described in Figure 4A. First, provide two flexible substrates, Substrate 1 and Substrate 2, both with a first and second surfaces (step 410D). Apply a first patterned conductive layer to the first surface of Substrate 1, the pattern forming a first array of connectors (step 420D). Apply a second patterned conductive layer to the first surface of Substrate 2, the pattern forming a second array of connectors (step 430D). Generate a number of vias in both substrates, some of the vias are positioned corresponding to ends of a corresponding array of connectors (step 440D).

Fill some of the vias of both substrates with a different type of thermoelectric material (step 450D). In some cases, every other via is filled with the thermoelectric material. Fill the rest of the vias of both substrates with an electrically conductive material (step 460D). For example, half of the vias of Substrate 1 are filled with p-type thermoelectric material and the rest of vias of Substrate 1 are filled with the conductive material; and half of the vias of Substrate 2 are filled with n-type thermoelectric material and the rest of vias of Substrate 2 are filled with the conductive material. In some cases, the electrically conductive material can be in the form of solution, ink, paste, or solid. In some cases, the electrically conductive material is filled in the vias by any feasible process, for example, by printing, by vacuum deposition, by silk screen printing, or the like.

Optionally, apply an electrically conductive bonding or adhesive material to the second surface of one or both substrates (step 465D). Place thermoelectric elements on the second surface of Substrate 2 aligning with vias in Substrate 2 (step 460D). Optionally, fill spaces between the thermoelectric elements with insulator (step 465D). Align and attach both substrates by facing the second surface toward each other such that vias filled with a thermoelectric material in Substrate 1 are aligned with vias filled with the electrically conductive material in Substrate 2 (step 470D). Similarly, vias filled with the electrically conductive material in Substrate 1 are aligned with vias filled with a thermoelectric material in Substrate 2. In such implementations, the conductive layers are on the outer surfaces of the assembly. Optionally, heat the attached substrates in order to strengthen the connections between the filled vias of both substrates and finish lamination (step 475D).

### Examples

### Example 1

### Thermoelectric Module with Metal filled Vias

The thermoelectric modules as represented in Figures 1C were assembled. As illustrated in Figure 1C, 1.0 mm vias 115 were punctured into a 0.1 mm thick 200 x 50 mm flexible polyimide substrate 110 obtained from 3M Company of St. Paul, MN every 2.5 mm. The vias were made by chemically milling through the substrate 110. The vias 115 were filled with copper deposited into the vias 115 by chemical vapor deposition (CVD) and electrochemical deposition. A 0.2 mm layer of Anisotropic Conductive Adhesive 7379 obtained from 3M Company of St. Paul, MN was deposited on top of the copper filled vias 115 as the bonding component 150. Alternating p-type Sb₂Te₃ and n-type Bi₂Te₃ 0.5 mm-thick thermoelectric elements 122, 124 obtained from Thermonamic, Inc. in Jiangxi China were deposited onto bonding component 150 covering the vias 115 by element transfer. 0.5-thick mm polyurethane insulators 160 were positioned between the thermoelectric elements 122, 124 by drop-on-demand printing. 4.3 x 1.8 x 0.1 mm copper connectors 130 were deposited by electrochemical deposition on the second substrate 112. 4.3 x 1.8 x 0.1 mm silver connectors 140 were deposited through silk screen printing on the first substrate surface 111 of the flexible polyimide substrate to connect the p-type and n-type thermoelectric elements 122, 124.

### Example 2

### Thermoelectric Module with Thermoelectric Element filled Vias

The thermoelectric modules as represented in Figures ID were assembled. As illustrated in Figure ID, 1.0 mm vias 115 were punctured into a 0.1 mm thick 200 x 50 mm flexible polyimide substrate 110 obtained from 3M Company of St. Paul, MN every 2.5 mm. The vias were made by chemically milling through the substrate 110. The vias 115 were filled with alternating p-type Sb₂Te₃ and n-type Bi₂Te₃ thermoelectric elements 122, 124 ink-formulated by the powders obtained from Super Conductor Materials, Inc. of Tallman, NY that were deposited into the vias 115 by silk screen printing. 4.3 x 1.8 x 0.1 mm copper connectors 130 were deposited by electrochemical deposition on the second substrate surface 112. 4.3 x 1.8 x 0.1 mm silver connectors 140 were deposited through silk screen printing on the first substrate surface 111 of the flexible polyimide substrate to connect the p-type and n-type thermoelectric elements 122, 124.

### Example 3

### Thermoelectric Tape

A thermoelectric module constructed in a tape form as represented in Figure 3A was assembled. A 0.1 mm-thick flexible polyimide substrate was manufactured in 3M Company of St. Paul, MN to construct a 30 meter-long tape incorporating multiple thermoelectric modules 310. A polyimide substrate having 30 µm-thick copper conductive buses (321, 322) connected longitudinally arranged thermoelectric modules 310 electrically in parallel. The thermoelectric module assembled in Example 1 was used to construct the tape's single module (311). A silver particle loaded Conductive Adhesive Transfer Tape 9704 from 3M Company of St. Paul, MN was used for the thermally conductive adhesive layer 330.

## Claims

1. A flexible thermoelectric module (100D) comprising:
a flexible substrate (110) having a thickness between 20 and 200 micrometers with a first surface (111) and an opposing second surface (112);
a first patterned conductive layer on the first surface (111) of the flexible substrate (110), wherein the pattern of the first conductive layer forms a first array of connectors (140) and each connector has two ends;
a plurality of vias (115) in the flexible substrate (110), wherein at least some of the vias (115) are positioned corresponding to ends of the first array of connectors (140);
at least some of the vias (115) filled with a thermoelectric material (117);
a second patterned conductive layer on the second surface (112) of the flexible substrate (110),
wherein the pattern of the second conductive layer forms a second array of connectors (130) and each connector (130) has two ends, and
wherein at least some of the ends of the second array of connectors (130) are positioned corresponding to at least some of the vias (150).

2. The flexible thermoelectric module of claim 1, wherein the thermoelectric material (117) comprises a binder material.

3. The flexible thermoelectric module of claim 1, comprising a thermally conductive adhesive material on the second patterned conductive layer.

4. The flexible thermoelectric module of claim 1, wherein a unit area thermal resistance of the flexible thermoelectric module is no greater than 1.0 K-cm²/W.

5. The flexible thermoelectric module of claim 1, wherein the thermoelectric material (117) comprises at least one of a chalcogenide, an organic polymer, an organic composite, and a porous silicon.

6. A flexible thermoelectric module (100A) comprising:
a flexible substrate (110) having a thickness between 20 and 200 micrometers with a first surface (111) and an opposing second surface (112);
a first patterned conductive layer (130) on the second surface of the flexible substrate (110), wherein the pattern on the first conductive layer forms (130) a first array of connectors and each connector has two ends;
a plurality of vias (115) in the flexible substrate (110), wherein at least some of the vias (115) are positioned corresponding to ends of the first array of connectors (130);
at least some of the vias (115) filled with an electrically conductive material, wherein the two ends of each connector (130) are electrically connected to adjacent vias (115);
thermoelectric elements (120, 122, 124) including a plurality of p-type thermoelectric elements (122) and a plurality of n-type thermoelectric elements (124) on the first surface (111) of the substrate (110) aligned with the vias (115);
a second patterned conductive layer on top of the thermoelectric elements (120, 122, 124),
wherein the pattern of the second conductive layer forms a second array of connectors (140) and each connector (140) has two ends, and
wherein at least some of the ends of the second array of connectors (140) are positioned corresponding to at least some of the thermoelectric elements (120, 122, 124).

7. The flexible thermoelectric module of claim 6, wherein at least one of the thermoelectric elements comprises a binder material.

8. The flexible thermoelectric module of claim 6, comprising a thermally conductive adhesive material on the first or second conductive layer.

9. The flexible thermoelectric module of claim 6, wherein an insulator is disposed among the thermoelectric elements.

10. The flexible thermoelectric module of claim 6, wherein a bonding component is disposed between one of the thermoelectric elements and a via.

11. The flexible thermoelectric module of claim 1 or 6, wherein the thickness of the thermoelectric module is no greater than 1 mm.

12. The flexible thermoelectric module of claim 6, wherein an abrasion protective layer is disposed adjacent to at least one of the first and second conductive layers.

13. A method for producing a flexible thermoelectric module (100D) comprising the steps of:
providing a flexible substrate (110) having a thickness between 20 and 200 micrometers with a first surface (111) and an opposing second surface (112);
applying a first patterned conductive layer to the first surface (111) of the flexible substrate (110), wherein the pattern of the first conductive layer forms a first array of connectors (140) and each connector has two ends;
generating a plurality of vias (115) in the flexible substrate (110) by removing materials from the flexible substrate (110), wherein at least some of the vias (115) are positioned corresponding to ends of the first array of connectors (140);
filling at least some of the vias (115) with a thermoelectric material (117);
applying a second patterned conductive layer to the second surface (112) of the flexible substrate (110),
wherein the pattern of the second conductive layer forms a second array of connectors (130) and each connector (130) has two ends, and
wherein at least some of the ends of the second array of connectors (130) are positioned corresponding to at least some of the vias (150).

14. The method of claim 13, wherein the thermoelectric material comprises a binder material, and the method further comprises the step of:
heating the thermoelectric module to remove the binder material.

15. The method of claim 13, wherein the step of applying a first patterned conductor layer precedes the step of filling at least one of the vias with a thermoelectric material.

16. A method for producing a flexible thermoelectric module (100A) comprising the steps of:
providing a flexible substrate (110) having a thickness between 20 and 200 micrometers with a first surface (111) and an opposing second surface (112);
applying a first patterned conductive layer (130) to the second surface of the flexible substrate (110), wherein the pattern of the first conductive layer forms (130) a first array of connectors and each connector has two ends;
generating a plurality of vias (115) in the flexible substrate (110) by removing materials from the flexible substrate (110), wherein at least some of the vias (115) are positioned corresponding to ends of the first array of connectors (130);
filling at least some of the vias (115) with an electrically conductive material, wherein the two ends of each connector (130) are electrically connected to adjacent vias (115);
placing thermoelectric elements (120, 122, 124) including a plurality of p-type thermoelectric elements (122) and a plurality of n-type thermoelectric elements (124) on the first surface (111) of the substrate (110) aligning with the vias (115);
printing a second patterned conductive layer on top of the thermoelectric elements (120, 122, 124),
wherein the pattern of the second conductive layer forms a second array of connectors (140) and each connector (140) has two ends, and
wherein at least some of the ends of the second array of connectors (140) are positioned corresponding to at least some of the thermoelectric elements (120, 122, 124).

17. The method of claim 16, wherein at least one of the thermoelectric elements comprises a binder material, and the method further comprises the step of: heating the thermoelectric module to remove the binder material.

## Patentansprüche

1. Flexibles thermoelektrisches Modul (100D), aufweisend:
ein flexibles Substrat (110) mit einer Dicke zwischen 20 und 200 Mikrometern mit einer ersten Oberfläche (111) und einer gegenüberliegenden zweiten Oberfläche (112);
eine erste strukturierte leitfähige Schicht auf der ersten Oberfläche (111) des flexiblen Substrats (110), wobei die Struktur der ersten leitfähigen Schicht eine erste Anordnung von Verbindern (140) bildet und jeder Verbinder zwei Enden aufweist;
eine Mehrzahl von Durchkontaktierungen (115) in dem flexiblen Substrat (110), wobei mindestens einige der Durchkontaktierungen (115) entsprechend Enden der ersten Anordnung von Verbindern (140) angeordnet sind;
wobei mindestens einige der Durchkontaktierungen (115) mit einem thermoelektrischen Material (117) gefüllt sind;
eine zweite strukturierte leitfähige Schicht auf der zweiten Oberfläche (112) des flexiblen Substrats (110),
wobei die Struktur der zweiten leitfähigen Schicht eine zweite Anordnung von Verbindern (130) bildet und jeder Verbinder (130) zwei Enden aufweist und
wobei mindestens einige der Enden der zweiten Anordnung von Verbindern (130) entsprechend mindestens einigen der Durchkontaktierungen (150) angeordnet sind.

2. Flexibles thermoelektrisches Modul nach Anspruch 1, wobei das thermoelektrische Material (117) ein Bindemittelmaterial aufweist.

3. Flexibles thermoelektrisches Modul nach Anspruch 1, aufweisend ein thermisch leitfähiges Klebematerial auf der zweiten strukturierten leitfähigen Schicht.

4. Flexibles thermoelektrisches Modul nach Anspruch 1, wobei der thermische Widerstand einer Flächeneinheit des flexiblen thermoelektrischen Moduls nicht mehr als 1,0 K-cm²/W beträgt.

5. Flexibles thermoelektrisches Modul nach Anspruch 1, wobei das thermoelektrische Material (117) mindestens eines von einem Chalkogenid, einem organischen Polymer, einem organischen Verbundstoff und einem porösen Silicium aufweist.

6. Flexibles thermoelektrisches Modul (100A), aufweisend:
ein flexibles Substrat (110) mit einer Dicke zwischen 20 und 200 Mikrometern mit einer ersten Oberfläche (111) und einer gegenüberliegenden zweiten Oberfläche (112);
eine erste strukturierte leitfähige Schicht (130) auf der zweiten Oberfläche des flexiblen Substrats (110), wobei die Struktur auf der ersten leitfähigen Schicht (130) eine erste Anordnung von Verbindern bildet und jeder Verbinder zwei Enden aufweist;
eine Mehrzahl von Durchkontaktierungen (115) in dem flexiblen Substrat (110), wobei mindestens einige der Durchkontaktierungen (115) entsprechend Enden der ersten Anordnung von Verbindern (130) angeordnet sind;
wobei mindestens einige der Durchkontaktierungen (115) mit einem elektrisch leitfähigen Material gefüllt sind, wobei die zwei Enden jedes Verbinders (130) mit benachbarten Durchkontaktierungen (115) elektrisch verbunden sind;
thermoelektrische Elemente (120, 122, 124), einschließlich einer Mehrzahl von thermoelektrischen Elementen (122) vom p-Typ und einer Mehrzahl von thermoelektrischen Elementen (124) vom n-Typ, auf der ersten Oberfläche (111) des Substrats (110), die an den Durchkontaktierungen (115) ausgerichtet sind;
eine zweite strukturierte leitfähige Schicht auf den thermoelektrischen Elementen (120, 122, 124),
wobei die Struktur der zweiten leitfähigen Schicht eine zweite Anordnung von Verbindern (140) bildet und jeder Verbinder (140) zwei Enden aufweist und
wobei mindestens einige der Enden der zweiten Anordnung von Verbindern (140) entsprechend mindestens einigen der thermoelektrischen Elemente (120, 122, 124) angeordnet sind.

7. Flexibles thermoelektrisches Modul nach Anspruch 6, wobei mindestens eines der thermoelektrischen Elemente ein Bindemittelmaterial aufweist.

8. Flexibles thermoelektrisches Modul nach Anspruch 6, aufweisend ein thermisch leitfähiges Klebematerial auf der ersten oder der zweiten leitfähigen Schicht.

9. Flexibles thermoelektrisches Modul nach Anspruch 6, wobei ein Isolator zwischen den thermoelektrischen Elementen angeordnet ist.

10. Flexibles thermoelektrisches Modul nach Anspruch 6, wobei eine Verbindungskomponente zwischen einem der thermoelektrischen Elemente und einer Durchkontaktierung angeordnet ist.

11. Flexibles thermoelektrisches Modul nach Anspruch 1 oder 6, wobei die Dicke des thermoelektrischen Moduls nicht mehr als 1 mm beträgt.

12. Flexibles thermoelektrisches Modul nach Anspruch 6, wobei eine Abriebschutzschicht angrenzend an mindestens eine von der ersten und der zweiten leitfähigen Schicht angeordnet ist.

13. Verfahren zum Herstellen eines flexiblen thermoelektrischen Moduls (100D), aufweisend die Schritte:
Bereitstellen eines flexiblen Substrats (110) mit einer Dicke zwischen 20 und 200 Mikrometern mit einer ersten Oberfläche (111) und einer gegenüberliegenden zweiten Oberfläche (112);
Aufbringen einer ersten strukturierten leitfähigen Schicht auf der ersten Oberfläche (111) des flexiblen Substrats (110), wobei die Struktur der ersten leitfähigen Schicht eine erste Anordnung von Verbindern (140) bildet und jeder Verbinder zwei Enden aufweist;
Erzeugen einer Mehrzahl von Durchkontaktierungen (115) in dem flexiblen Substrat (110) durch Entfernen von Materialien von dem flexiblen Substrat (110), wobei mindestens einige der Durchkontaktierungen (115) entsprechend Enden der ersten Anordnung von Verbindern (140) angeordnet sind;
Füllen mindestens einiger der Durchkontaktierungen (115) mit einem thermoelektrischen Material (117);
Aufbringen einer zweiten strukturierten leitfähigen Schicht auf die zweite Oberfläche (112) des flexiblen Substrats (110),
wobei die Struktur der zweiten leitfähigen Schicht eine zweite Anordnung von Verbindern (130) bildet und jeder Verbinder (130) zwei Enden aufweist und
wobei mindestens einige der Enden der zweiten Anordnung von Verbindern (130) entsprechend mindestens einigen der Durchkontaktierungen (150) angeordnet sind.

14. Verfahren nach Anspruch 13, wobei das thermoelektrische Material ein Bindemittelmaterial aufweist und das Verfahren ferner den Schritt aufweist:
Erwärmen des thermoelektrischen Moduls, um das Bindemittelmaterial zu entfernen.

15. Verfahren nach Anspruch 13, wobei der Schritt des Aufbringens einer ersten strukturierten leitfähigen Schicht dem Schritt des Füllens mindestens einer der Durchkontaktierungen mit einem thermoelektrischen Material vorausgeht.

16. Verfahren zum Herstellen eines flexiblen thermoelektrischen Moduls (100A), aufweisend die Schritte:
Bereitstellen eines flexiblen Substrats (110) mit einer Dicke zwischen 20 und 200 Mikrometern mit einer ersten Oberfläche (111) und einer gegenüberliegenden zweiten Oberfläche (112);
Aufbringen einer ersten strukturierten leitfähigen Schicht (130) auf der zweiten Oberfläche des flexiblen Substrats (110), wobei die Struktur der ersten leitfähigen Schicht (130) eine erste Anordnung von Verbindern bildet und jeder Verbinder zwei Enden aufweist;
Erzeugen einer Mehrzahl von Durchkontaktierungen (115) in dem flexiblen Substrat (110) durch Entfernen von Materialien von dem flexiblen Substrat (110), wobei mindestens einige der Durchkontaktierungen (115) entsprechend Enden der ersten Anordnung von Verbindern (130) angeordnet sind;
Füllen mindestens einiger der Durchkontaktierungen (115) mit einem elektrisch leitfähigen Material, wobei die zwei Enden jedes Verbinders (130) mit benachbarten Durchkontaktierungen (115) elektrisch verbunden sind;
Anordnen der thermoelektrischen Elemente (120, 122, 124), einschließlich einer Mehrzahl von thermoelektrischen Elementen (122) vom p-Typ und einer Mehrzahl von thermoelektrischen Elementen (124) vom n-Typ, auf der ersten Oberfläche (111) des Substrats (110), die an den Durchkontaktierungen (115) ausgerichtet sind;
Drucken einer zweiten strukturierten leitfähigen Schicht auf die thermoelektrischen Elemente (120, 122, 124),
wobei die Struktur der zweiten leitfähigen Schicht eine zweite Anordnung von Verbindern (140) bildet und jeder Verbinder (140) zwei Enden aufweist und
wobei mindestens einige der Enden der zweiten Anordnung von Verbindern (140) entsprechend mindestens einigen der thermoelektrischen Elemente (120, 122, 124) angeordnet sind.

17. Verfahren nach Anspruch 16, wobei mindestens eines der thermoelektrischen Elemente ein Bindemittelmaterial aufweist und das Verfahren ferner den Schritt aufweist:
Erwärmen des thermoelektrischen Moduls, um das Bindemittelmaterial zu entfernen.

## Revendications

1. Module thermoélectrique flexible (100D) comprenant :
un substrat flexible (110) ayant une épaisseur entre 20 et 200 micromètres avec une première surface (111) et une deuxième surface opposée (112) ;
une première couche conductrice à motifs sur la première surface (111) du substrat flexible (110), dans lequel le motif de la première couche conductrice forme un premier réseau de connecteurs (140) et chaque connecteur a deux extrémités ;
une pluralité de trous d'interconnexion (115) dans le substrat flexible (110), dans lequel au moins certains des trous d'interconnexion (115) sont positionnés en correspondance avec des extrémités du premier réseau de connecteurs (140) ;
au moins certains des trous d'interconnexion (115) remplis avec un matériau thermoélectrique (117) ;
une deuxième couche conductrice à motifs sur la deuxième surface (112) du substrat flexible (110),
dans lequel le motif de la deuxième couche conductrice forme un deuxième réseau de connecteurs (130) et chaque connecteur (130) a deux extrémités, et
dans lequel au moins certaines des extrémités du deuxième réseau de connecteurs (130) sont positionnées en correspondance avec au moins certains des trous d'interconnexion (150).

2. Module thermoélectrique flexible selon la revendication 1, dans lequel le matériau thermoélectrique (117) comprend un matériau liant.

3. Module thermoélectrique flexible selon la revendication 1, comprenant un matériau adhésif thermoconducteur sur la deuxième couche conductrice à motifs.

4. Module thermoélectrique flexible selon la revendication 1, dans lequel une résistance thermique de surface unitaire du module thermoélectrique flexible n'est pas supérieure à 1,0 K-cm²/W.

5. Module thermoélectrique flexible selon la revendication 1, dans lequel le matériau thermoélectrique (117) comprend au moins l'un parmi un chalcogénure, un polymère organique, un composite organique, et un silicium poreux.

6. Module thermoélectrique flexible (100A) comprenant :
un substrat flexible (110) ayant une épaisseur entre 20 et 200 micromètres avec une première surface (111) et une deuxième surface opposée (112) ;
un première couche conductrice à motifs (130) sur la deuxième surface du substrat flexible (110), dans lequel le motif sur la première couche conductrice (130) forme un premier réseau de connecteurs et chaque connecteur a deux extrémités ;
une pluralité de trous d'interconnexion (115) dans le substrat flexible (110), dans lequel au moins certains des trous d'interconnexion (115) sont positionnés en correspondance avec des extrémités du premier réseau de connecteurs (130) ;
au moins certains des trous d'interconnexion (115) remplis d'un matériau électroconducteur, dans lequel les deux extrémités de chaque connecteur (130) sont connectées électriquement à des trous d'interconnexion adjacents (115) ;
des éléments thermoélectriques (120, 122, 124) incluant une pluralité d'éléments thermoélectriques de type p (122) et une pluralité d'éléments thermoélectriques de type n (124) sur la première surface (111) du substrat (110) alignés avec les trous d'interconnexion (115) ;
une deuxième couche conductrice à motifs au-dessus des éléments thermoélectriques (120, 122, 124),
dans lequel le motif de la deuxième couche conductrice forme un deuxième réseau de connecteurs (140) et chaque connecteur (140) a deux extrémités, et
dans lequel au moins certaines des extrémités du deuxième réseau de connecteurs (140) sont positionnées en correspondance avec au moins certains des éléments thermoélectriques (120, 122, 124).

7. Module thermoélectrique flexible selon la revendication 6, dans lequel au moins l'un des éléments thermoélectriques comprend un matériau liant.

8. Module thermoélectrique flexible selon la revendication 6, comprenant un matériau adhésif thermoconducteur sur la première ou deuxième couche conductrice.

9. Module thermoélectrique flexible selon la revendication 6, dans lequel un isolant est disposé parmi les éléments thermoélectriques.

10. Module thermoélectrique flexible selon la revendication 6, dans lequel un composant de liaison est disposé entre l'un des éléments thermoélectriques et un trou d'interconnexion.

11. Module thermoélectrique flexible selon la revendication 1 ou 6, dans lequel l'épaisseur du module thermoélectrique n'est pas supérieure à 1 mm.

12. Module thermoélectrique flexible selon la revendication 6, dans lequel une couche protectrice anti-abrasion est disposée adjacente à au moins l'une des première et deuxième couches conductrices.

13. Procédé de production d'un module thermoélectrique flexible (100D) comprenant les étapes consistant à :
fournir un substrat flexible (110) ayant une épaisseur entre 20 et 200 micromètres avec une première surface (111) et une deuxième surface opposée (112) ;
appliquer une première couche conductrice à motifs sur la première surface (111) du substrat flexible (110), dans lequel le motif de la première couche conductrice forme un premier réseau de connecteurs (140) et chaque connecteur a deux extrémités ;
générer une pluralité de trous d'interconnexion (115) dans le substrat flexible (110) en retirant des matériaux du substrat flexible (110), dans lequel au moins certains des trous d'interconnexion (115) sont positionnés en correspondance avec des extrémités du premier réseau de connecteurs (140) ;
remplir au moins certains des trous d'interconnexion (115) avec un matériau thermoélectrique (117) ;
appliquer une deuxième couche conductrice à motifs sur la deuxième surface (112) du substrat flexible (110),
dans lequel le motif de la deuxième couche conductrice forme un deuxième réseau de connecteurs (130) et chaque connecteur (130) a deux extrémités, et
dans lequel au moins certaines des extrémités du deuxième réseau de connecteurs (130) sont positionnées en correspondance avec au moins certains des trous d'interconnexion (150).

14. Procédé selon la revendication 13, dans lequel le matériau thermoélectrique comprend un matériau liant, et le procédé comprend en outre l'étape consistant à :
chauffer le module thermoélectrique pour éliminer le matériau liant.

15. Procédé selon la revendication 13, dans lequel l'étape d'application d'une première couche conductrice à motifs précède l'étape de remplissage d'au moins l'un des trous d'interconnexion avec un matériau thermoélectrique.

16. Procédé de production d'un module thermoélectrique flexible (100A) comprenant les étapes consistant à :
fournir un substrat flexible (110) ayant une épaisseur entre 20 et 200 micromètres avec une première surface (111) et une deuxième surface opposée (112) ;
appliquer une première couche conductrice à motifs (130) sur la deuxième surface du substrat flexible (110), dans lequel le motif de la première couche conductrice (130) forme un premier réseau de connecteurs et chaque connecteur a deux extrémités ;
générer une pluralité de trous d'interconnexion (115) dans le substrat flexible (110) en retirant des matériaux du substrat flexible (110), dans lequel au moins certains des trous d'interconnexion (115) sont positionnés en correspondance avec des extrémités du premier réseau de connecteurs (130) ;
remplir au moins certains des trous d'interconnexion (115) d'un matériau électroconducteur, dans lequel les deux extrémités de chaque connecteur (130) sont connectées électriquement à des trous d'interconnexion adjacents (115) ;
placer des éléments thermoélectriques (120, 122, 124) incluant une pluralité d'éléments thermoélectriques de type p (122) et une pluralité d'éléments thermoélectriques de type n (124) sur la première surface (111) du substrat (110) en alignement avec les trous d'interconnexion (115) ;
imprimer une deuxième couche conductrice à motifs au-dessus des éléments thermoélectriques (120, 122, 124),
dans lequel le motif de la deuxième couche conductrice forme un deuxième réseau de connecteurs (140) et chaque connecteur (140) a deux extrémités, et
dans lequel au moins certaines des extrémités du deuxième réseau de connecteurs (140) sont positionnées en correspondance avec au moins certains des éléments thermoélectriques (120, 122, 124).

17. Procédé selon la revendication 16, dans lequel au moins l'un des éléments thermoélectriques comprend un matériau liant, et le procédé comprend en outre l'étape consistant à :
chauffer le module thermoélectrique pour éliminer le matériau liant.
